Europäisches Patentamt

European Patent Office

Office européen des brevets

(11) Publication number: **0 267 599 B1**

# EUROPEAN PATENT SPECIFICATION

(45) Date of publication of patent specification: **15.04.92**    (51) Int. Cl.⁵: **G02B 3/00**, G02B 19/00, G02B 7/02

(21) Application number: **87116667.4**

(22) Date of filing: **11.11.87**

(54) Fly eye lens unit for illumination.

(30) Priority: **11.11.86 JP 172952/86**

(43) Date of publication of application:
    **18.05.88 Bulletin 88/20**

(45) Publication of the grant of the patent:
    **15.04.92 Bulletin 92/16**

(84) Designated Contracting States:
    **DE FR GB IT**

(56) References cited:
    **DE-A- 2 803 277**
    **DE-A- 2 939 204**
    **FR-A- 2 526 962**
    **US-A- 3 296 923**

    **PATENT ABSTRACTS OF JAPAN, vol. 8, no. 252 (P-314)[1689], 17th November 1984; & JP - A - 59 123 805**

(73) Proprietor: **Dainippon Screen Mfg. Co., Ltd.**
    **1-1, Tenjinkitamachi Teranouchi-Agaru**
    **4-chome Horikawa-Dori**
    **Kamikyo-ku Kyoto 602(JP)**

(72) Inventor: **Uemura, Haruo**
    **206 Oyagi Mansion 71 Nishii-cho**
    **Kamikatsura Nishikyo-ku Kyoto(JP)**

(74) Representative: **Goddar, Heinz J., Dr. et al**
    **FORRESTER & BOEHMERT Franz-**
    **Joseph-Strasse 38**
    **W-8000 München 40(DE)**

# Description

The present invention relates to an illumination system according to the first part of claim 1 as known from DE-A-2 939 204 and a fly eye lens unit according to the first part of claim 16, resp., as known from FR-A-2 526 962.

DE-A-2 939 204 discloses an illumination system with a fly eye lens unit, the construction of which is not shown. In the eye lens construction of FR-A-2 256 962 there is only one plane of element lenses extending transverse to the optical path.

It is the object of the present invention to provide an illumination system and a fly eye lens unit for such system, resp., which illuminates an object with an uniform irradiance distribution.

This object is accomplished by the features of the second part of claim 1 and claim 16, resp. Subject matter of sub claims 2 to 15 are preferred embodiments of the illumination system according to claim 1.

Other novel features and advantages of the present invention will become apparent in the course of the following detailed description taken together with the accompanying drawings, which are directed only to the understanding of the present invention and not to the restriction of the scope off the invention.

Figure 1 is a schematic view of an illumination system embodying the present invention;

Figure 2 is a perspective cross-sectional view showing a fly eye lens unit, in its halved state, embodying the present invention;

Figure 3 is a perspective analytical view of a first embodiment of the fly eye lens unit shown in Figure 2;

Figures 4-A and 4-B are a perspective view and a plane view of an element lens, respectively;

Figure 5 is a perspective analytical view of a second embodiment of the fly eye lens unit according to the present invention; and

Figures 6 through 8 are illustrative views for showing assembling operations of the fly eye lens unit.

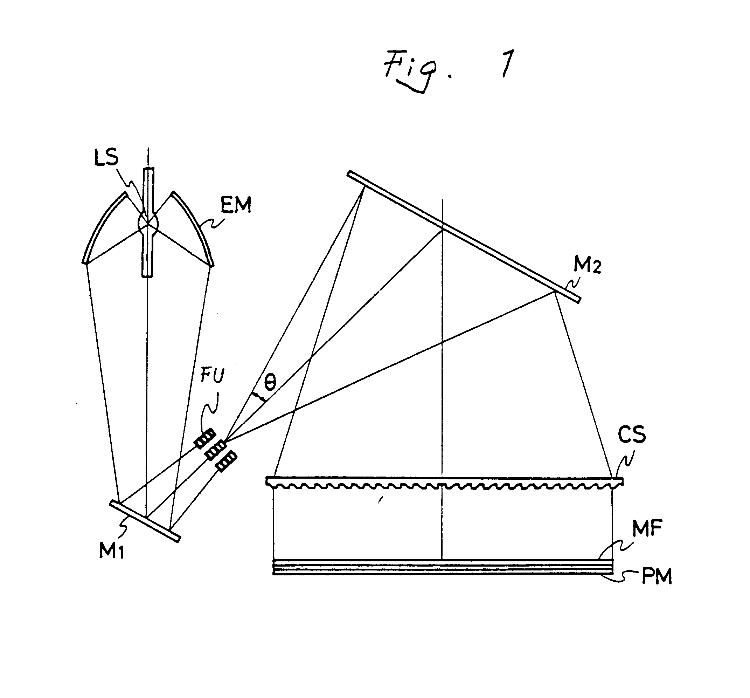

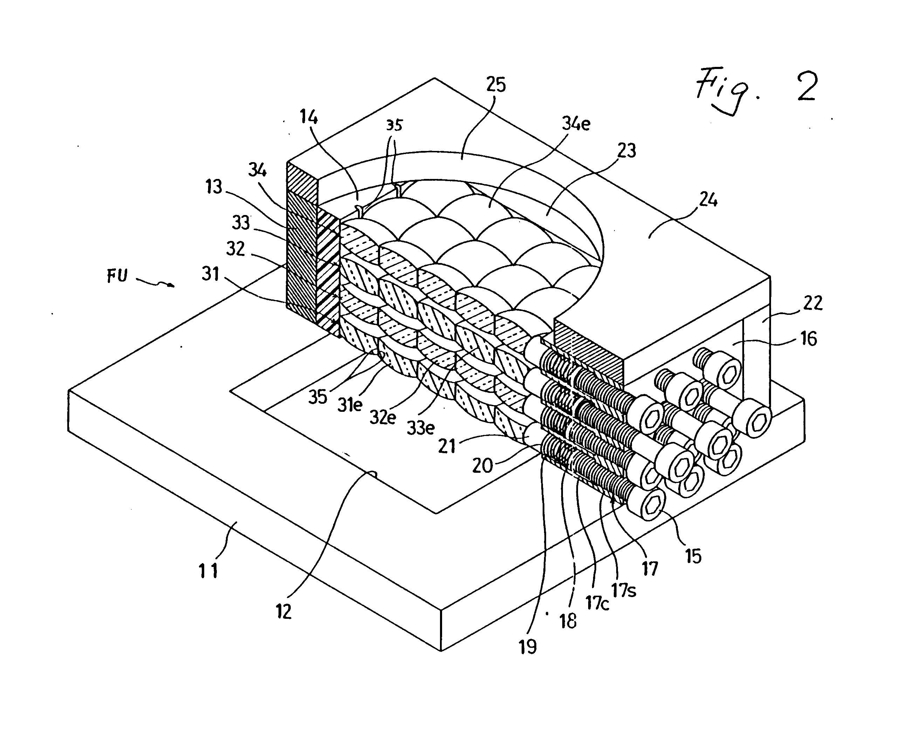

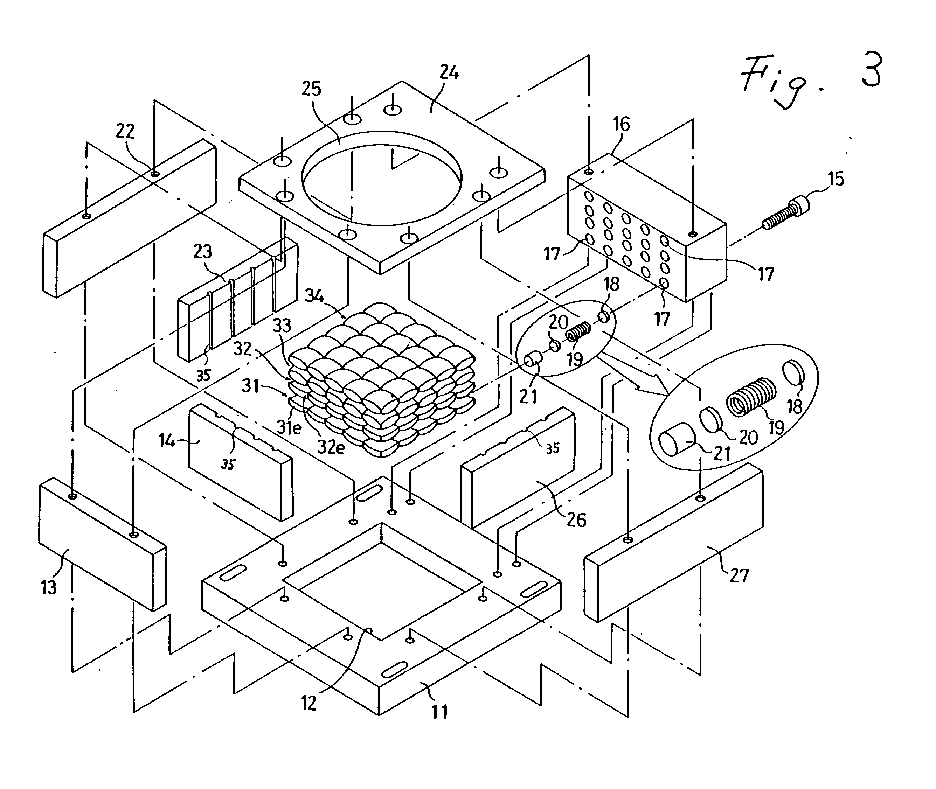

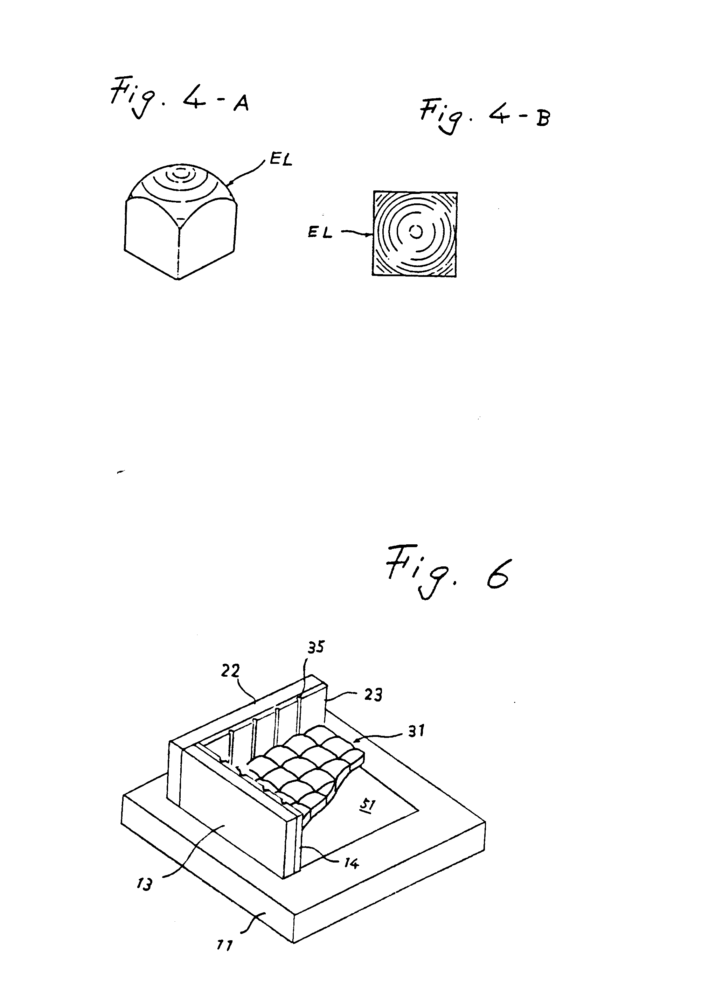

Referring to Figure 1, which shows an illumination system embodying the present invention, the illumination system generally comprises a light source LS, an ellipsoidal mirror EM disposed with respect to the light source, a first folding mirror $M_1$, a fly eye lens unit FU, a second folding mirror $M_2$, a collimation system CS, a mask film MF bearing desired circuit patterns thereon and a photosensitive material PM, respectively disposed along the optical path in order.

The light source LS is positioned at or adjacent to the first focal point off the ellipsoidal mirror EM, so that light emitted from the light source is condensed and directed to the fly eye lens unit FU through the folding mirror $M_1$. The folding mirror $M_1$ comprises so-called a cold mirror which allows most of infrared radiation to pass therethrough and reflects most of ultraviolet radiation.

The fly eye lens unit FU is positioned at a point adjacent to the second focal point of the ellipsoidal mirror EM, which is preferred in order to form the secondary light source thereby, since light emitted from the light source is most condensed at this point. However, it is sufficient if the fly eye lens unit FU is disposed at a position optically nearer to the light source LS than that as mentioned above, as long as the light directed toward the fly eye lens unit FU is received within the effective area thereof. Light condensed by the ellipsoidal mirror EM enters the fly eye lens unit FU to impinge upon the incident surface of the collimation system CS.

The characteristics of the fly eye lens unit FU as an optical system is designed so that the following equation is substantially established:

$$h = K \tan \theta$$

where h is an entrance height of a light beam, k is a proportional constant and $\theta$ is an exit angle from the fly eye lens unit.

On such an optical system having the aforementioned characteristics, the detailed description is shown in the European Patent Application No. 87101235.7 (Publication No. 0 231 029). Accordingly, the detailed discussion thereon is omitted here.

The fly eye lens structure is very useful for resolving the irradiance non-uniformity at the entrance pupil of such optical system, which enables the incident surface of the collimation system CS to be illuminated uniformly independent of the irradiance distribution at the entrance pupil. Moreover, respective element lenses of the fly eye lens unit provides uniform irradiance through the entire area of the incident surface of the collimation system, thus the irradiance distribution on the incident surface of the collimation system will become uniform.

The illumination system shown in Figure 1 is designed so that the entrance pupil of the fly eye lens unit FU is conjugated with the incident surface of the collimation system CS, accordingly light passing through a predetermined common point in the entrance pupil will impinge upon a predetermined common point on the incident surface of the collimation system, and consequently light emitted from the light source and received in the entrance pupil will illuminate the predetermined area of the incident surface of the collimation system, without any loss of light.

The collimation system CM comprises a single Fresnel lens, which is advantageous to reduce the optical path between the light source LC and an object to be illuminated. The photosensitive material PM is positioned immediately under the mask film MF, and exposure of a desired circuit pattern is made accurately and effectively on the photosensitive material.

Referring to Figures 2 and 3, which show a structural outline of a first embodiment of a fly eye lens unit FU according to the present invention, the fly eye lens unit generally comprises a base frame 11 defining a square opening 12, side walls 13, 16, 22 and 27, spacer plates 14, 23 and 26, a multiple structure of element lenses 31 to 34, and a lid plate 24 defining a circular opening 25 thereon.

The base frame 11 is made of aluminum alloy, and the square opening 12 defined thereon is adapted to pass light rays from a light source. The square opening 12 defines an exit aperture of the fly eye lens uuit FU, which has a large inner diameter not to block the light beam exited from the fly eye lens unit.

The respective side walls 13, 16, 22 and 27 is also made of aluminum alloy, and is secured upright on the respective peripheral edges of the base frame 11. On the side wall 16, there defined are small bores suitable for allowing the insertion of screws 15 therethrough. Each of the bores 17 has a threaded section 17s and a non-threaded cylindrical section 17c therein.

The threads provided in the threaded section 17s is designed to be engageable with those of the screw. The non-threaded section 17c has a larger diameter than that of the threaded section 17s. The non-threaded section 17c accomodates a biasing means comprising a first metal disk 18, a coil spring 19, a second metal disk 20 of the same shape as that of the first disk 18, and a contact element 21 made of fluorine-contained polymers, in order. The respective bores 17 on the side wall 16 are positioned at positions corresponding to respective rows of the element lenses aligned in respect of the corresponding screws 15.

The respective spacer plates 14, 23 and 26 is made of fluorine-contained polymers, and is closely disposed between the respective side walls 13, 22 and 27 and the assembly of the element lenses 31 to 34, respectively. It is preferable to chose fluorine-contained polymers as the spacer plates because of its elasticity and heat insulating characteristics. However, it may be also applicable to use any materials having appropriate elasticity for absorbing the thermal expansion either of the element lenses or metallic base frame and side walls, and having appropriate heat insulating characteristics for blocking the heat transmission from the metallic base frame and side walls to the element lenses, or vice versa.

On the inner surface of the spacer means there provided are a plurality of grooves 35 extending in the vertical direction. Positions of the grooves 35 are determined so as to correspond to respective adjacent element lenses on the matrices. Air existing between respective matrices of the element lenses can freely communicate with the outside thereof.

Respective element lenses 31e to 34e constitute four units of matrices 31 to 34, and each of these matrices includes 5 X 5 pieces of element lenses EM. Each matrix of the element lenses is assembled only by the biasing forces of the coil springs 19, without any adhesive agent or the like. The biasing force to be applied to each row of element lenses in respect of the Corresponding screw 15 is adjusted by the screw, and according to experimental demonstrations it was preferable to apply the biasing force in the range of 1.0 to 1.5 kg to respective rows of the element lenses.

The element lenses in each of the matrices have substantially the same optical characteristics. Each of the element lenses EL has an incident surface and an exit surface having a predetermined curvature, respectively, and four plane side surfaces, as best shown in Figures 4-A and 4-B It is especially preferable to form a precise square by the side surfaces in the plane view. The adjacent element lenses in each matrix are closely in contact with each other, without any intermedium.

The adjacent matrices disposed along the optical axis are spaced from each other by a predetermined distance, where respective optical axes of the element lenses EL in each matrix are precisely coincident with each other. The distance between the adjacent matrices is determined on the basis of the optical characteristics on an object to be illuminated.

The lid plate 24 is also made of aluminum alloy, and defines an circular opening 25 thereon. The circular opening 25 defines an incident aperture of the fly eye lens unit FU, where the inner diameter of the opening 25 is designed so that the light beam converging on the fly eye lens unit should not be blocked by the lid plate.

In the aforementioned embodiment, assemblage of the respective element lenses is accomplished only by the biasing forces of the biasing coil springs 19, which are applied to the rows aligned in respect of the screws from a longitudinal direction and are appropriately adjusted only by manipulating respective screws.

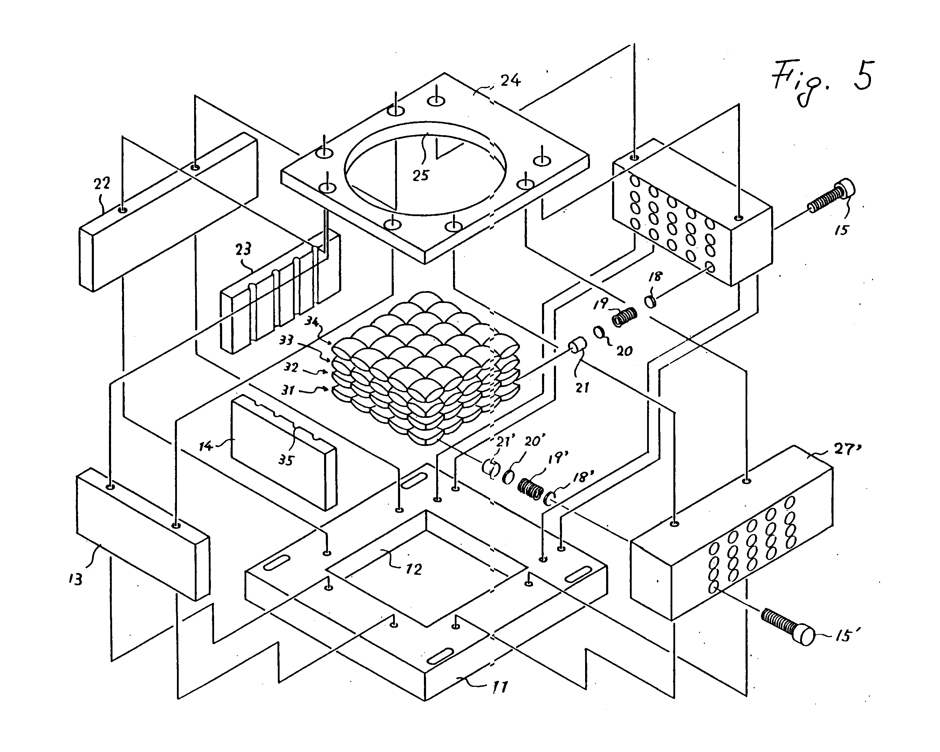

Referring to Figure 5, which shows a second embodiment of a fly eye lens unit FU according to the present invention, the same reference numerals as in Figure 3 denote the same elements. In this embodiment, a side wall 27' is comprised substantially in the same manner as the side wall 16, and the spacer plate 26 in Figure 3 is replaced by assemblies of biasing means as those in Figure 3, each of which includes screw 15', a first disk plate 18', a coil spring 19', a second disk plate 20' and a contact element 21'. The biasing force applied to the respective rows in respect of the screws 15' is adjusted to be smaller by approximately 500g than that applied to the respective rows of the screws 15.

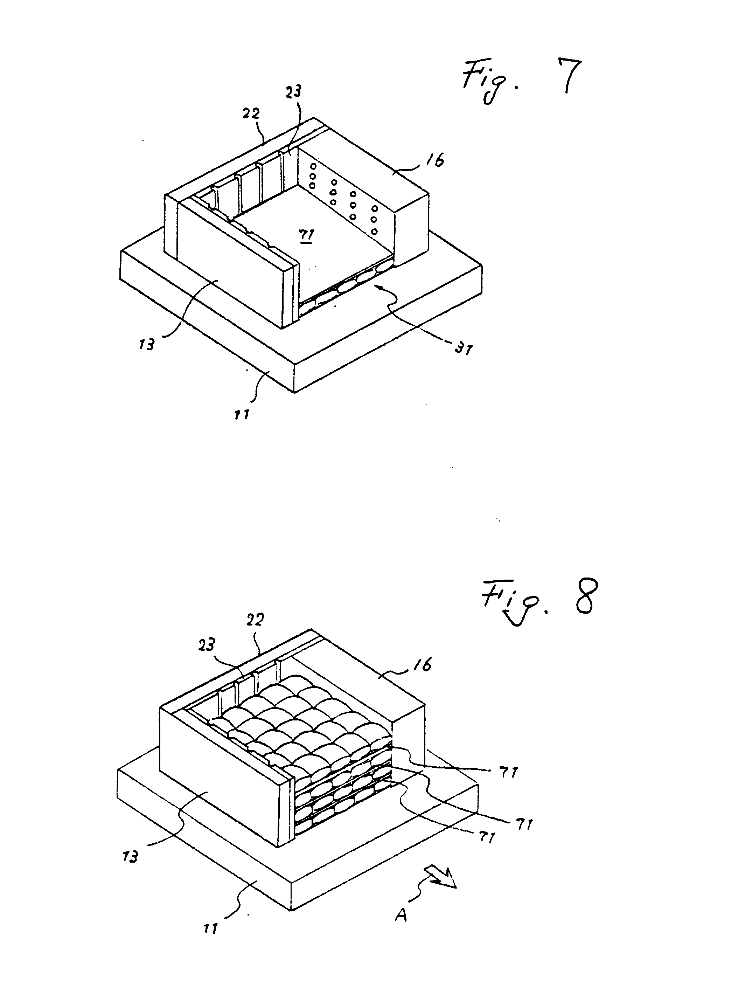

Referring to Figures 6 through 8, when assembling the fly eye lens unit, first both the side walls 13 and 22 are fixed to the base frame 11, and the spacer plates 14 and 23 are mounted along these side walls. Then, an appropriate square plate 51 corresponding to the square opening 12 is placed within the opening. The fourth (i.e. lowermost) matrix 31 of element lenses are aligned, on the square plate 51, along the side walls 13 and 22. After that, the side wall 16 is mounted to the base frame 11, where the respective bores 17 accomodates a biasing means comprising the contact element 21, the coil spring 19 and a pair of the metal disks 18 and 19. Then, Screws 15 are set to the bores 17, applying the biasing forces to the rows aligned in respect of the screws. Thus, the respective rows of the element lenses is fixedly held by the biasing forces.

Next, as shown in Figure 7, an adjusting plate 71 is placed on the fourth (i.e. lowermost) matrix 31 of the element lenses, where the adjusting plate 71 has a thickness precisely corresponding to the distance between the fourth matrix 31 of the element lenses and the third matrix 32 thereof. The element lenses of the third matrix 32 are aligned in the same manner as those of the fourth matrix.

In such a manner as above, four matrices of element lenses are superposed in order. Respective rows of the element lenses in the each matrix are fixedly held by the biasing forces. Then, as shown in Figure 8, the respective adjusting plates 71 interposed between the matrices are drawn in the direction of an arrow A, and are removed from the fly eye lens unit.

Then, the spacer plate 26 and the side wall 27 are fixedly mounted on the base frame 11, in the case of the first embodiment shown in Figure 3, or the side wall 27' having substantially the same structure as the side wall 16 is fixedly mounted on the base frame 11, in the case of the second embodiment shown in Figure 5. After that, the lid plate 24 is mounted on the side walls, whereby assembling of the fly eye lens unit is accomplished.

As mentioned above, since the fly eye lens unit FU is positioned at a point adjacent to the second focal point of the ellipsoidal mirror EM, the fly eye lens unit FU will be heated considerably, in spite of interposition of the cold mirror $M_1$. However, since the spacer plates having heat insulating characteristics are interposed between the element lenses and a housing comprising the base frame, side walls and lid plate of aluminum alloy, the thermal transmission from the housing to the element lenses, or vice virsa, is efficiently blocked. Even if the thermal expansion may occur in the fly eye lens unit, it is efficiently absorbed by the spacer plates 14, 23 and 26 and the biasing means, and accordingly the optical characteristics of the fly eye lens unit is kept substantially constant.

Since there is no intermediate between respective element lenses of the fly eye lens unit, light entering the fly eye lens unit is not blocked and passes therethrough without any loss of light.

## Claims

1. An illumination system for illuminating an object including a light source (LS), converging means (EM) disposed with respect to said light source (LS) for converging light emitted from said light source (LS), a fly eye lens unit (FU) disposed at a converging point of said converging means (EM); collimation means (CS) for collimating light rays exited from said fly eye lens unit (FU) and an object disposed along the optical path of said illumination system,

   characterized in that said fly eye lens unit (FU) comprises:
   - a first frame (24) defining an incident aperture thereon;
   - a second frame (11) defining an exit aperture thereon;
   - a plurality of element lenses orderly aligned in a plane, said element lenses being closely in contact with each other;
   - side walls (13, 16, 22, 27) disposed between said first and second frames (24, 11) for housing said element lenses therein;
     wherein
   - said element lenses form a plurality of rows lying in a plane extending transverse to the optical path;
   - said fly eye lens unit (FU) comprises a plurality of such planes, each plane comprising a plurality of rows of element lenses, said planes being parallel to each other, and
   - said fly eye lens unit (FU) further comprises biasing means (18, 19, 20, 21) each assigned to one of the rows for applying an adjustable biasing force to each row of the element lenses in a direction transverse to the optical path.

2. An illumination system as set forth in claim 1, wherein a plurality of bores (17) are provided on at least one of said side walls (13, 16, 22, 27), said bores (17) being defined at positions corresponding to the respective rows of the element lenses, and said biasing means (18, 19, 20, 21) are accommodated in the respective bores (17).

3. An illumination system as set forth in claim 1 or 2, wherein said biasing means (18, 19, 20, 21) comprises a contact member (21) for contacting with an element lens aligned in a corresponding row of the element lenses, a biasing coil spring (19) for applying a biasing force to a corresponding row of the element lenses and adjusting means (15) for adjusting the biasing force.

4. An illumination system as set forth in claim 3, wherein said rows of the element lenses are formed in a matrix.

5. An illumination system as set forth in claim 4, wherein said element lenses are formed in a plurality of matrices.

6. An illumination system as set forth in claim 3, wherein said adjusting means comprises a screw (15), and said respective bores (17) includes a threaded section (17s) engageable with said screw (15).

7. An illumination system as set forth in claim 3, wherein said contact member (21) comprises a material having heat insulating characteristics.

8. An illumination system as set forth in claim 3, wherein said contact member (21) comprises a material having elasticity adaptable for absorbing the thermal expansion of elements.

9. An illumination system as set forth in claim 1, further comprising spacer means (14, 23, 26) disposed closely between said respective side walls (13, 16, 22, 27) and said element lenses.

10. An illumination system as set forth in claim 9, wherein said spacer means (14, 23, 26) comprises a resin plate made of fluorine-contained polymers.

11. An illumination system as set forth in claim 9, said spacer means (14, 23, 26) comprises a material having heat insulating characteristics.

12. An illumination system as set forth in claim 9, said spacer means (14, 23, 26) comprises a material having elasticity adaptable for absorbing the thermal expansion of elements.

13. An illumination system as set forth in either one of claims 9 through 12, wherein said spacer means (14, 23, 26) comprises a plurality of grooves (35) extending along the optical axes of the respective element lenses, respective grooves (35) corresponding to borders of respective adjacent element lenses.

14. An illumination system as set forth in claim 1, wherein said incident aperture provided on the first frame (24) has an enough inner diameter to receive light rays directed toward the fly eye lens unit.

15. An illumination system as set forth in claim 1, wherein said exit aperture provided on the second frame has an enough inner diameter to pass light rays received in the fly eye lens unit.

16. A fly eye lens unit, comprising:
   - a first frame (24) defining an incident aperture (25) of the fly eye lens thereon;
   - a second frame (11) defining an exit aperture (12) of the fly eye lens thereon;
   - a plurality of element lenses orderly aligned in a plane, said element lenses being closely in contact with each other;
   - side walls (13, 16, 22, 27) disposed between said first and second frames (24, 11) for housing said element lenses therein;
   - said element lenses forming a plurality of rows lying in the plane, said plane extending transverse to the optical path; characterized in that the fly eye lens unit (FU) comprises a plurality of such planes, each plane comprising a plurality of rows of element lenses, said planes being parallel to each other, and in
   - that said fly eye lens unit (FU) further comprises biasing means (18, 19, 20, 21) each assigned to one of the rows for applying an adjustable biasing force to each row of the element lenses in a direction transverse to the optical path.

**Revendications**

1. Dispositif d'illumination d'un objet comprenant une source de lumière (LS), un moyen de convergence (EM) placé par rapport à ladite source de lumière (LS) pour faire converger la lumière émise par ladite source de lumière (LS), une lentille en oeil de mouche (FU) placée en un point de convergence dudit moyen de convergence (EM), un moyen collimateur (CS) pour orienter les rayons lumineux sortant de ladite lentille en oeil de mouche (FU) et un objet placé le long du trajet optique dudit dispositif d'illumination, dispositif caractérisé en ce que ladite lentille en oeil de mouche (FU) comprend :

- une premier cadre (24) définissant une ouverture incidente;
- un second cadre (11) définissant une ouverture de sortie ;
- plusieurs lentilles élémentaires alignées dans l'ordre dans un plan, lesdites lentilles élémentaires étant en contact intime l'une avec l'autre;
- des parois latérales (13, 16, 22, 27) placées entre lesdits premier et second cadres (24, 11) pour loger lesdites lentille élémentaires;

     dans lequel
- lesdites lentilles élémentaires forment plusieurs rangées s'étendant dans un plan transversal au trajet optique;
- ladite lentille en oeil de mouche (FU) comprend plusieurs de tels plans, chaque plan comprenant plusieurs rangées de lentilles élémentaires, lesdits plans étant parallèles mutuellement et
- ladite lentille en oeil de mouche (FU) comprend de plus des moyens de poussée (18 à 21), chacun de ces moyens étant assigné à une des rangées pour appliquer un effort de poussée réglable à chaque rangée de lentilles élémentaires dans une direction transversale au trajet optique.

2. Dispositif d'illumination selon la revendication 1, dans lequel plusieurs alésages (17) sont prévus sur au moins une desdites parois latérales (13, 16, 22, 27), lesdits alésages (17) étant définis en des positions correspondant aux rangées respectives des lentilles élémentaires et lesdits moyens de poussée (18 à 21) sont logés dans les alésages respectifs (17).

3. Dispositif d'illumination selon la revendication 1 ou 2, dans lequel lesdits moyens de poussée (18 à 21) comprennent une pièce de contact (21) avec une lentille élémentaire alignée dans une rangée correspondante de lentilles élémentaires, un ressort hélicoïdal de poussée (19) pour appliquer une force de poussée à une rangée correspondante de lentilles élémentaires et un moyen de réglage (17) de la force de poussée.

4. Dispositif d'illumination selon la revendication 3, dans lequel lesdites rangées de lentilles élémentaires forment une matrice.

5. Dispositif d'illumination selon la revendication 4, dans lequel lesdites lentilles élémentaires forment plusieurs matrices.

6. Dispositif d'illumination selon la revendication 3, dans lequel lesdits moyens de réglages comprennent une vis (15) et lesdits alésages respectifs (17) comprennent une section taraudée (17s) pouvant coopérer avec ladite vis (15).

7. Dispositif d'illumination selon la revendication 3, dans lequel ladite pièce de contact (21) comprend un matériau possédant des caractéristiques d'isolation thermique.

8. Dispositif d'illumination selon la revendication 3, dans lequel ladite pièce de contact (21) comprend un matériau possédant une élasticité pouvant absorber la dilatation thermique des éléments.

9. Dispositif d'illumination selon la revendication 1, comprenant de plus des moyens d'espacement (14, 23, 26) placés en contact entre lesdites parois latérales respectives (13, 16, 22, 27) et lesdites lentilles élémentaires.

10. Dispositif d'illumination selon la revendication 9, dans lequel lesdits moyens d'espacement (14, 23, 26) comprennent une plaque en résine réalisée en polymères contenant de la fluorine.

11. Dispositif d'illumination selon la revendication 9, dans lequel lesdits moyens d'espacement (14, 23, 26) comprennent un matériau possédant des caractéristiques d'isolation thermique.

12. Dispositif d'illumination selon la revendication 9, dans lequel lesdits moyens d'espacement (14, 23, 26) comprennent un matériau possédant une élasticité pouvant absorber la dilatation thermique des éléments.

13. Dispositif d'illumination selon l'une quelconque des revendications 9 à 12, dans lequel lesdits moyens d'espacement (14, 23, 26) comprennent plusieurs gorges (35) s'étendant le long des axes optiques des lentilles élémentaires respectives, des gorges respectives (35) correspondant aux bordures des lentilles élémentaires respectives adjacentes.

14. Dispositif d'illumination selon la revendication 1, dans lequel ladite ouverture incidente prévue sur le premier cadre (24) possède une diamètre interne suffisant pour recevoir les rayons lumineux dirigés vers la lentille en oeil de mouche.

15. Dispositif d'illumination selon la revendication 1, dans lequel ladite ouverture de sortie prévue sur le second cadre possède un diamètre interne suffisant pour laisser passer les rayons lumineux reçus dans la lentille en oeil de mouche.

16. Lentille en oeil de mouche comprenant :
   - un premier cadre (24) définissant une ouverture incidente (25) de la lentille en oeil de mouche;
   - un second cadre (11) définissant une ouverture de sortie (12) de la lentille en oeil de mouche;
   - plusieurs lentilles élémentaires alignées dans l'ordre sur un plan, lesdites lentilles élémentaires étant en contact intime l'une avec l'autre;
   - des parois latérales (13, 16, 22, 27) placées entre lesdits premier et second cadres (24, 11) pour loger lesdites lentilles élémentaires;
   - lesdites lentilles élémentaires formant plusieurs rangées s'étendant dans le plan, ledit plan s'étendant transversalement au trajet optique;

     lentille caractérisée en ce que la lentille en oeil de mouche (FU) comprend plusieurs de tels plans, chaque plan comprenant plusieurs rangées de lentilles élémentaires, lesdits plans étant parallèles mutuellement et en ce que ladite lentille en oeil de mouche (FU) comprend de plus des moyens de poussée (18 à 21) assignés chacun à une des rangées pour appliquer une force de poussée réglable à chaque rangée de lentilles élémentaires dans une direction transversale au trajet optique.

**Patentansprüche**

1. Beleuchtungssystem zur Beleuchtung eines Objekts, mit einer Lichtquelle (LS), Konvergierungsmitteln (EM), die bezüglich der Lichtquelle (LS) angeordnet sind zum Konvergieren von von der Lichtquelle (LS) ausgesandtem Licht, einer Fliegenaugenlinseneinheit (FU), die an dem Brennpunkt der Konvergierungsmittel (EM) vorgesehen ist; Kollimationsmittel (CS) zum Kollimieren von von der Fliegenaugenlinseneinheit (FU) ausgestrahlten Lichtstrahlen und einem entlang des optischen Wegs des Beleuchtungssystems angeordneten Objekt,

dadurch gekennzeichnet, daß die Fliegenaugenlinseneinheit (FU) aufweist:
   - einen ersten Rahmen (24), der eine Eingangsöffnung definiert;
   - einen zweiten Rahmen (11), der eine Ausgangsöffnung definiert;
   - eine Mehrzahl von Elementlinsen, die in einer Ebene geordnet ausgerichtet angeordnet sind, wobei die Elementlinsen in engem Kontakt miteinander sind;
   - Seitenwände (13, 16, 22, 27), die zwischen dem ersten (24) und dem zweiten Rahmen (11) angeordnet sind zur Aufnahme der Linsen zwischen sich;
     wobei
   - die Elementlinsen eine Mehrzahl von Reihen ausbilden, die in einer Ebene liegen, die sich quer zu dem optischen Weg erstreckt;
   - die Fliegenaugenlinseneinheit (FU) eine Mehrzahl solcher Ebenen aufweist, die jeweils eine Mehrzahl von Reihen von Elementlinsen aufweisen und parallel zueinander angeordnet sind, und
   - die Fliegenaugenlinseneinheit (FU) weiter Vorspannmittel (18, 19, 20, 21) aufweisen, die jeweils einer der Reihen zugeordnet sind zum Aufbringen einer einstellbaren Vorspannkraft auf jede Reihe der Elementlinsen in einer Richtung quer zu dem optischen Weg.

2. Beleuchtungssystem nach Anspruch 1, wobei eine Mehrzahl von Bohrungen (17) in wenigstens einer der Seitenwände (13, 16, 22, 27) in einer den jeweiligen Reihen der Elementlinsen entsprechenden Positionen vorgesehen sind und die Vorspannmittel (18, 19, 20, 21) von den jeweiligen Bohrungen (17) aufgenommen werden.

3. Beleuchtungssystem nach Anspruch 1 oder 2, wobei die Vorspannmittel (18, 19, 20, 21) ein Kontaktelement (21) zum Kontaktieren einer in einer entsprechenden Reihe der Elementlinsen ausgerichteten Elementlinse, eine Vorspannspiralfeder (19) zum Aufbringen einer Vorspannkraft auf eine entsprechende Reihe der Elementlinsen und Justiermittel (15) zur Justierung der Vorspannkraft aufweisen.

4. Beleuchtungssystem nach Anspruch 3, wobei die Reihen der Elementlinsen in einer Matrix ausgebildet sind.

5. Beleuchtungssystem nach Anspruch 4, wobei die Elementlinsen in einer Mehrzahl von Matritzen ausgebildet sind.

6. Beleuchtungssystem nach Anspruch 3, wobei die Justiermittel eine Schraube (15) aufweisen und die jeweiligen Bohrungen (17) einen Gewindeabschnitt (175) aufweisen, der mit der Schraube (15) zusammenwirkt.

7. Beleuchtungssystem nach Anspruch 3, wobei das Kontaktelement (21) ein Material mit Wärmeisolationseigenschaften aufweist.

8. Beleuchtungssystem nach Anspruch 3, wobei das Kontaktelement (21) ein Material mit einer zum Aufnehmen der thermischen Expansion der Elemente geeigneten Elastizität aufweist.

9. Beleuchtungssystem nach Anspruch 1, weiter mit Abstandselementen (14, 23, 26), die eng zwischen den jeweiligen Seitenwänden (13, 16, 22, 27) und den Elementlinsen angeordnet sind.

10. Beleuchtungssystem nach Anspruch 9, wobei die Abstandsmittel (14, 23, 26) aus einer Fluor beinhaltende Polymäre aufweisenden Harzplatte besteht.

11. Beleuchtungssystem nach Anspruch 9, wobei die Abstandsmittel (14, 23, 26) ein Material mit Wärmeisolationseigenschaften aufweisen.

12. Beleuchtungssystem nach Anspruch 9, wobei die Abstandsmittel (14, 23, 26) ein Material aufweisen, das eine zur Absorption der thermischen Expansion der Elemente geeignete Elastizität aufweist.

13. Beleuchtungssystem nach einem der Ansprüche 9 bis 12, wobei die Abstandsmittel (14, 23, 26) eine Mehrzahl von Kerben (35) aufweisen, die sich entlang der optischen Achse der jeweiligen Elementlinsen erstrecken und die jeweiligen Kerben (35) den Grenzen der jeweils benachbarten Elementlinsen entsprechen.

14. Beleuchtungssystem nach Anspruch 1, wobei die an dem ersten Rahmen (24) angeordnete Eintrittsöffnung einen inneren Durchmesser aufweist, der ausreicht, um gegen die Fliegenaugenlinse gerichtete Lichtstrahlen aufzunehmen.

15. Beleuchtungssystem nach Anspruch 1, wobei die an dem zweiten Rahmen ausgebildete Austrittsöffnung einen Innendurchmesser hat, der ausreichend ist, um die von der Fliegenaugenlinseneinheit aufgenommenen Lichtstrahlen passieren zu lassen.

16. Fliegenaugenlinseneinheit, mit:
   - einem ersten Rahmen (24), der eine Eintrittsöffnung (25) der Fliegenaugenlinse bildet,
   - einem zweiten Rahmen (11), der eine Austrittsöffnung (12) der Fliegenaugenlinse bildet;
   - einer Mehrzahl von Elementlinsen, die in einer Ebene angeordnet sind, wobei die Elementlinsen in engem Kontakt zueinander sind;
   - Seitenwänden (13, 16, 22, 27), die zwischen dem ersten Rahmen (24) und dem zweiten Rahmen (11) angeordnet sind zur Aufnahme der Elementlinsen zwischen sich;
   - wobei die Elementlinsen eine Mehrzahl von in einer Ebene liegenden Reihen ausbilden, und die Ebene sich quer zu dem optischen Weg erstreckt;
   dadurch gekennzeichnet, daß
   - die Fliegenaugenlinseneinheit (FU) eine Mehrzahl derartiger Ebenen aufweist, wobei jede Ebene eine Mehrzahl von Reihen von Elementlinsen aufweist und die Ebenen parallel zueinander sind, und
   - die Fliegenaugenlinseneinheit (FU) weiter Vorspannmittel (18, 19, 20, 21) aufweist, die jeweils einer der Reihen zugeordnet sind zum Aufbringen einer einstellbaren Vorspannkraft auf jeder Reihe der Elementlinsen in einer Richtung quer zu dem optischen Weg.

Fig. 1

Fig. 2

Fig. 3

EP 0 267 599 B1

*Fig. 4 - A*

*Fig. 4 - B*

EL

EL

*Fig. 6*

Fig. 5

Fig. 7

Fig. 8